# EUROPÄISCHE PATENTSCHRIFT

(11) **EP 2 880 968 B1**
(45) Veröffentlichungstag und Bekanntmachung des Hinweises auf die Patenterteilung: **25.05.2016**
(21) Anmeldenummer: 14771249.1
(22) Anmeldetag: 16.09.2014
(51) Int. Cl.: H05K 5/02

(54) **VERRIEGELBARES DRUCKGEHÄUSE**
LOCKABLE PRESSURE CASING
CARTER SOUS PRESSION POUVANT ÊTRE VERROUILLÉ

(30) Priorität: 19.09.2013 DE 102013110383
(43) Veröffentlichungstag der Anmeldung: 10.06.2015
(73) Patentinhaber: Aesculap AG, 78532 Tuttlingen (DE)
(72) Erfinder: ZEPF, Rudolf, 78573 Wurmlingen (DE); SCHNEKENBURGER, Rolf, 78532 Tuttlingen (DE); KRAUSE, Ralf, 71154 Nufringen (DE); GUBA, Joachim, 71154 Nufringen (DE)
(74) Vertreter: Winter, Brandl, Fürniss, Hübner, Röss, Kaiser, Polte - Partnerschaft mbB
(86) Internationale Anmeldenummer: PCT/EP2014/069672
(87) Internationale Veröffentlichungsnummer: WO 2015/040011

(56) Entgegenhaltungen:
- EP-A2- 1 139 711
- US-A1- 2004 160 744
- US-A1- 2011 127 890
- US-A1- 2013 147 327

## Beschreibung

Die vorliegende Erfindung betrifft ein verriegelbares Gehäuse (Druckgehäuse) insbesondere eines medizinischen Geräts gemäß dem Oberbegriff des Patentanspruchs 1.

### Hintergrund der Erfindung

Insbesondere in der Medizintechnik aber auch im Bereich des Automobil- oder Flugzeugbaus besteht die grundsätzliche Notwendigkeit, elektrische Geräte und elektronische Bauteile in sogenannten Schutzgehäusen einzuhausen, welche zum Einen die Geräte und Bauteile gegen äußere Einwirkungen wie Feuchtigkeit, Schmutz und Schläge/Stöße/Vibrationen schützt und zum Anderen den Austritt von elektromagnetischen Wellen aus dem Gehäuse wirksam verhindert.

Derartige Gehäuse besitzen in der Regel wenigstens eine Montageöffnung, welche mit einer Montageklappe oder Haube verschlossen werden kann.

### Stand der Technik

Aus dem Stand der Technik sind Gehäuse der vorstehend beschriebenen Gattung hinreichend bekannt. Diese bestehend aus einer Bodenplatte, an der randseitig vier Seitenwänden angeschraubt oder angeschweißt sind. Ein Gehäusedeckel hat einen randseitig umlaufende Montagerahmen, der bei Aufsetzen des Deckels die Seitenwände über- oder hintergreift. Schließlich sind an den Seitenwänden wie auch am umlaufenden Montagerahmen Durchgangsbohrungen angebracht, in welche vorzugsweise Blech- oder Metallschrauben eingedreht werden können, um dadurch den Deckel an den Seitenwänden zu montieren.

Das Problem dieser allgemein bekannten Gehäusekonstruktion besteht darin, dass bereits kleinste Spalte oder Abstände zwischen den einzelnen Gehäuseteilen ausreichen, dass elektromagnetische Wellen aus dem Gehäuseinneren entweichen können. Auch dringen durch diese "Montagespalte" Staubpartikel und Feuchtigkeit, welche die eingehausten Bauteile beschädigen. Letztere könnte zwar durch entsprechende Dichtungen verhindert werden, diese aber sind in der Regel aus einen Kunststoffmaterial (nicht metallisch) gefertigt, und daher elektromagnetisch durchdringbar.

Um daher sowohl ein gegen Feuchtigkeit und Staub dichtes wie auch elektromagnetisch isoliertes Gehäuse bereit zu stellen, sind die einzelnen Gehäusekomponenten mit großer Präzision herzustellen und auch die Montage ist mit großem Aufwand zu betreiben. So müssen die Gehäuseteile mit Nut- und Federkanten versehen sein und die zur Verschraubung vorgesehenen Bohrungen müssen so präzise gesetzt sein, dass beim Verschrauben der einzelnen Gehäuseteile die vordefinierten Relativlagen nicht verändert werden. Dieser Aufwand in der Vorbereitung und Montage der Gehäuseteile macht das gesamte Gehäuse teuer und in der Handhabung unpraktisch.

### Kurzbeschreibung der Erfindung

Angesichts dieser Problematik ist es die Aufgabe der vorliegenden Erfindung, ein (Geräte-) Gehäuse vorzugsweise zu medizinischen Zwecken bereit zu stellen, das sich durch eine hohe Montage und Servicefreundlichkeit auszeichnet. Ein Ziel ist es vorzugsweise, die Montagezeit des Gehäuses und damit des gesamten (elektrischen/elektronischen) Geräts zu reduzieren. Ein weiteres Ziel ist es vorzugsweise, das Gehäuse als einen Faradayschen Käfig auszubilden, um erstens zu vermeiden, dass elektromagnetische Wellen/Strahlen aus dem Gehäuseinnern nach Außen dringen, aber auch zweitens keine Störstrahlung von Außen in das Gerätegehäuse eindringen kann.

Die Aufgabe und ggf. auch die weiteren Ziele der vorliegenden Erfindung werden durch ein (medizinisches) Gerätegehäuse mit den Merkmalen des anliegenden Patentanspruchs 1 gelöst. Vorteilhafte Ausgestaltungen sind Gegenstand der Unteransprüche.

Der Erfindung liegt die Überlegung zugrunde, die bis dahin als lösbare Verbindungselemente zwischen zwei Gehäuseteilen eingesetzten Schrauben nunmehr nur noch indirekt als Stellmechanismen zu Betätigung eines Verriegelungsmechanismus zu verwenden. Grundsätzlich hat ein solcher erfindungsgemäße Verriegelungsmechanismus zur Verbindung zweier Gehäuseteile einen Riegel oder Schieber mit einer Hinterschneidung/Rastnase und einer Rampe, wobei der Riegel/Schieber an einem ersten Gehäuseteil verschiebbar gelagert und vorzugsweise mittels der Stellschraube oder einem anderen Stellmechanismus, wie beispielweise ein Kniehebel, von außen betätigbar ist. An einem zweiten Gehäuseteil ist ein erstes Angriffsmittel für die Hinterschneidung/Rastnase und ein zweites Angriffsmittel für die Rampe angeordnet/ausgebildet.

Die beiden Angriffsmittel sowie die Hinterschneidung/Rastnase sind so platziert, dass bei einer Verriegelungsbewegung des Riegels/Schiebers die Hinterschneidung/Rastnase mit dem ersten Angriffsmittel in Wirkeingriff kommt, wohingegen die Rampe vom zweiten Angriffsmittel außer Wirkeingriff kommt. Somit wird das erste Eingriffsmittel und damit das zugehörige Gehäuseteil zum Riegel/Schieber und damit zum zugehörigen Gehäuseteil hingezogen. Wird statt dessen der Riegel/Schieber in einer Öffnungs-/Freigabebewegung betätigt, kommt die Hinterschneidung/Rastnase von dem ersten Angriffsmittel außer Wirkeingriff, wohingegen die Rampe mit dem zweiten Angriffsmittel in Wirkeingriff kommt. Dadurch wird das zweite Angriffsmittel und damit das zugehörige Gehäuseteil vom Riegel/Schieber und damit vom zugehörigen Gehäuseteil weggedrückt.

In anderen Worten ausgedrückt, wird gemäß einem Aspekt der vorliegenden Erfindung ein Gehäuse eines elektrischen oder elektronischen Geräts vorzugsweise der medizinischen Bauart mit einer Zugangshaube, Zugangsdeckel oder dergleichen Gehäuseteil vorgeschlagen, das für ein Verschließen des Gehäuses oder einer Gehäuseöffnung mittels eines von Außerhalb des Gehäuses betätigbaren Verriegelungsmechanismus am Gehäuse fixierbar ist. Der Verriegelungsmechanismus hat wenigstens einen an einem ersten Gehäuseteil nämlich am Gehäuse oder an der Zugangshaube/Zugangsdeckel längsverschiebbar gehaltenen Riegel/Schieber an dem eine Rampe und eine hierzu in Schieberichtung beabstandeter Hinterschneidung oder eine Rastnase vorgesehen ist, wohingegen an einem zweiten Gehäuseteil, nämlich an der Zugangshaube/Zugangsdeckel oder dem Gehäuse wenigstens ein Vorsprung vorgesehen ist, der zur Definition zweier Angriffsmittel so ausgebildet und/oder angeordnet ist, dass er in Abhängigkeit von der aktuellen Schiebeposition des Riegels/Schiebers wechselweise mit der zugehörigen Rastnase für ein Heranziehen oder mit der Rampe für ein Wegdrücken der Zugangshaube/Zugangsdeckel an das/von dem Gehäuse in Wirkeingriff kommt.

Durch die Ausbildung des Riegels/Schiebers mit der Rastnase kann auf zwei miteinander zu verbindenden Gehäuseteile eine enorme Verspannkraft aufgebracht werden, welche die beiden Gehäuseteile aneinander zieht. Diese Verspannkraft ergibt sich zum einen aus der Form der Rastnase, welche nach Art eine Hakens das Angriffsmittel, beispielsweise in Form eines bolzenartigen Vorsprungs zunehmend hintergreift und damit immer weiter heranzieht und aus der Art des Stellmechanismus zur Betätigung der Riegels/Schiebers, beispielsweise in Form einer Stellschraube. Um diese enorme Verspannkraft, welche auch eine Selbsthemmung des Verriegelungsmechanismus bewirkt, wieder zu lösen und die beiden miteinander verspannten Gehäuseteile freizugeben, ist die Rampe vorgesehen, welche keilförmig gegen das zugehörige Angriffsmittel, beispielsweise ebenfalls in Form eines bolzenartigen Vorsprungs drückt, während oder nachdem die Rastnase deren Angriffsmittel freigibt/freigegeben hat. Somit können beide zunächst fest miteinander verbundene Gehäuseteile zwangsweise voneinander getrennt werden.

Diese Konstruktion des Verriegelungsmechanismus erlaubt es, die Kontaktstellen beider Gehäuseteile so zu optimieren, dass sie undurchlässig für elektromagnetische Strahlung wird. Beispielsweise kann eine Nut- und Feder - Verbindung zwischen den beiden Gehäuseteilen vorgesehen sein, die so gestaltet ist, dass eine dichte Pressverbindung entsteht. Da der Verriegelungsmechanismus sowohl in Verriegelungs-als auch in Freigaberichtung Zwangskräfte auf die beiden Gehäuseteile ausübt, kann auf diese Weise die Pressverbindung zwangsweise hergestellt aber auch wieder gelöst werden.

Vorzugsweise hat das erfindungsgemäße Gehäuse eine Bodenplatte, eine Anzahl von Seitenwänden sowie die zumindest eine Zugangshaube oder Zugangsdeckel, die, wie vorstehend bereits ausgeführt wurde, weiter vorzugsweise nach dem Nut- und Feder-Prinzip miteinander zusammensteckbar sind. Hierfür kann zumindest an der Gehäuseinnenseite der Bodenplatte längs deren Umfang zumindest eine oder mehrere Nuten ausgebildet sein, deren jeweilige Nutentiefe senkrecht zur Gehäuseinnenseite ausgerichtet ist zur hochkantigen Steckaufnahme der Seitenwände und vorzugsweise der Zugangshaube/Zugangsdeckel. Natürlich kann/können derartige Nuten auch an der Zugangshaube/Zugangsdeckel und/oder den Seitenwänden vorgesehen sein, derart, dass das aus den genannten Teilen zusammengesteckte Gehäuse an ausgewählte oder allen Längskanten die Nut-/Feder-Verbindung aufweist.

Gemäß einem anderen Aspekt der vorliegenden Erfindung sind an zumindest einem oder ausgewählten Gehäuseteilen nämlich der Bodenplatte, den Seitenwänden und/oder der Zugangshaube/Zugangsdeckel randseitig eine Anzahl von seriell beabstandeten Führungszapfen an der jeweiligen Gehäuseinnenseite des entsprechenden Gehäuseteils ausgeformt, die zur Längsführung des Riegels/Schiebers vorgesehen sind. Der Riegel/Schieber kann vorzugsweise aus einem Blechbauteil gefertigt sein, wobei dieser aber auch ein Metallgussteil sein kann.

Vorzugsweise hat der Riegel/Schieber eine Anzahl von seriell längsbeabstandeten Durchgangslängsschlitzen, in welche die Führungszapfen längsgleitend eingesetzt oder einsetzbar sind. D.h. die Führungszapfen bilden zusammen mit den Durchgangslängsschlitzen eine Art Kulissenführung für den Riegel/Schieber. Alternativ wäre aber auch eine Schwalbenschwanzführung, eine Gardinen-Führung oder dergleichen Führungskulisse denkbar. Vorteilhaft ist es, wenn die Führung ein unbeabsichtigtes Abheben des Riegels/Schiebers verhindert. Im Fall von Führungszapfen können diese mit axialen Innengewinden ausgebildet sein, in welche nach Aufsetzen des Riegels/Schiebers Halteschrauben eingedreht werden können.

Gemäß einem weiteren oder anderen Aspekt der Erfindung ist eine Betätigungseinrichtung zur Längsverschiebung des jeweiligen Riegels/Schiebers von Außerhalb des Gehäuses vorgesehen. Dieser Betätigungsmechanismus kann beispielsweise eine Stellschraube sein, welche an einem ausgewählten Gehäuseteil nämlich der Bodenplatte, den Seitenplatten und/oder der Zugangshaube/Zugangsdeckel in Schieberichtung des zugehörigen Riegels/Schiebers eingedreht und stirnseitig mit dem zugehörigen Riegel/Schieber in Eingriff ist, um diesen in seine Längsrichtung zu drücken und zu ziehen. Es gibt aber auch andere Formen für die Betätigungseinrichtung wie beispielsweise eine Kniehebelkonstruktion.

Weiter vorteilhaft ist es, wenn der zumindest eine Vorsprung durch ein separates Angriffsmittel-Bauteil bereitgestellt wird, welches an ausgewählte Gehäuseteile nämlich der Bodenplatte, den Seitenwänden und/oder der Zugangshaube/Zugangsdeckel fixiert/fixierbar ist. Dadurch wird zum Einen das jeweilige Gehäuseteil, an welches das Angriffsmittel-Bauteil anmontiert wird, hierdurch verstärkt/ausgesteift und zum Anderen kann das Angriffsmittel-Bauteil bei dessen Montage fein justiert werden, um eine gute Funktion des Verriegelungsmechanismus im Zusammenspiel mit dem zugehörigen Riegel/Schieber zu gewährleisten.

Vorzugsweise ist das Angriffsmittel-Bauteil als Blech- oder Metallgussbauteil ausgebildet mit einer Anzahl von laschen- oder bolzenförmigen, längsbeabstandeten Vorsprüngen, welche jeweils ein oder zwei Angriffsmittel für das Zusammenwirken mit der Rastnase und/oder der Rampe am Riegel/Schieber definieren.

### Figurenbeschreibung

Die Erfindung wird nachstehend anhand eines bevorzugten Ausführungsbeispiels unter Bezugnahme auf die anliegenden Figuren näher erläutert.
Fig. 1 zeigt einen Teil eines vorzugsweise medizinischen Gerätegehäuses gemäß einem bevorzugten Ausführungsbeispiel der Erfindung,
Fig. 2 zeigt ein Angriffsmittel-Bauteil zur Montage an Gehäuseteilen des vorzugsweise medizinischen Gerätegehäuses und
Fig. 3. zeigt einen Schieber als Bestandteil eines Verriegelungsmechanismus gemäß dem bevorzugten Ausführungsbeispiel der Erfindung.

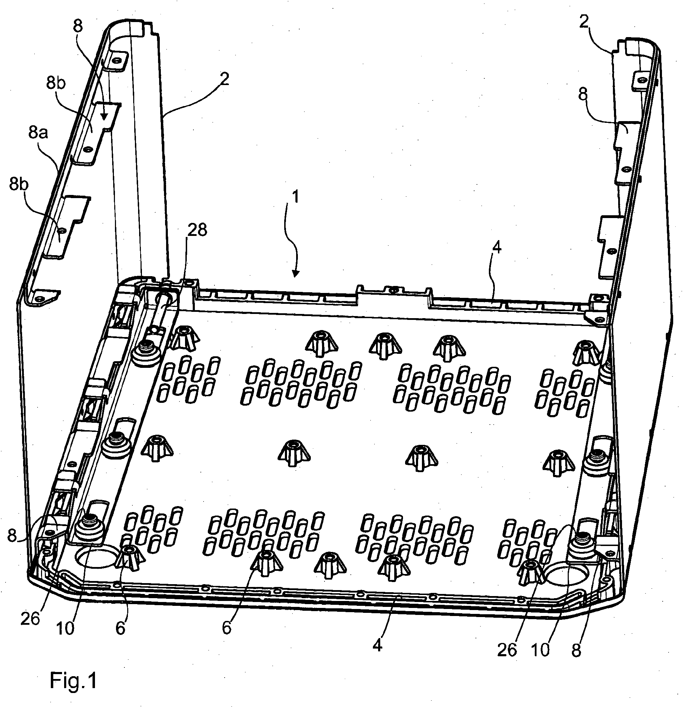

Das in Fig. 1 teilweise dargestellte Gerätegehäuse hat eine Bodenplatte 1, wenigstens zwei mit der Bodenplatte 1 zu verbindende Seitenplatten 2 sowie eine nicht weiter dargestellte, im Querschnitt vielleicht U-förmig gebogene Haube, die demnach integral zwei weitere Seiteplatten sowie einen Deckel einstückig ausbildet. Alternativ hierzu kann natürlich auch jede Seite des Gehäuses einschließlich Boden und Deckel jeweils aus einem einzelnen Plattenelement gebildet sein.

Gemäß der Fig. 1 hat die Bodenplatte 1 an ihrer Gehäuseinnenseite eine randseitig umlaufende Nut oder Nuten 4, in welche die Seitenplatten 2 nach dem Nut- und Federprinzip hochkant einsteckbar sind bzw. eingesteckt sind. Des weiteren sind längs der Nuten 4 eine Anzahl von im Wesentlichen gleichmäßig beabstandeten Anschraubsockeln oder Zapfen 6 mit Innengewinde ausgeformt.

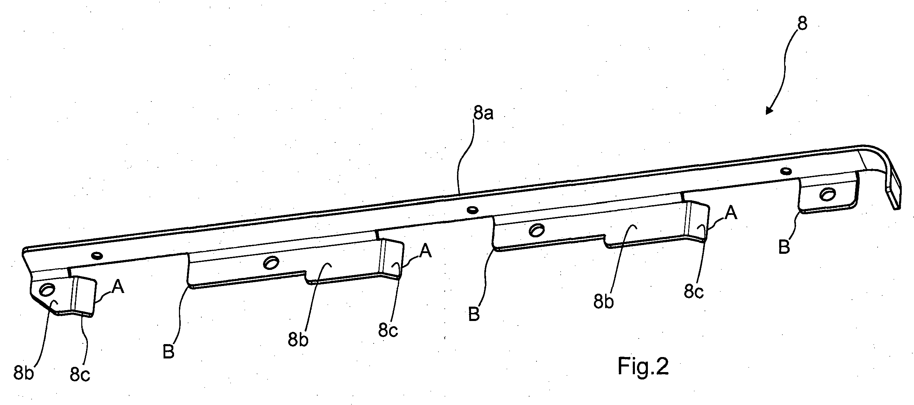

In der Fig. 1 ist das nur teilweise dargestellte Gehäuse mit zwei sich gegenüberliegenden Seitenplatten 2 versehen, welche in die bereits vorstehend genannten Nuten 4 hochkant eingesteckt oder eingepresst sind. An jeder Seitenplatte 2 ist ferner randseitig jeweils ein sogenanntes Angriffsmittel-Bauteil 8 montiert (angeschraubt/angenietet/angeschweißt/etc.), wie es in der Fig. 2 gezeigt ist.

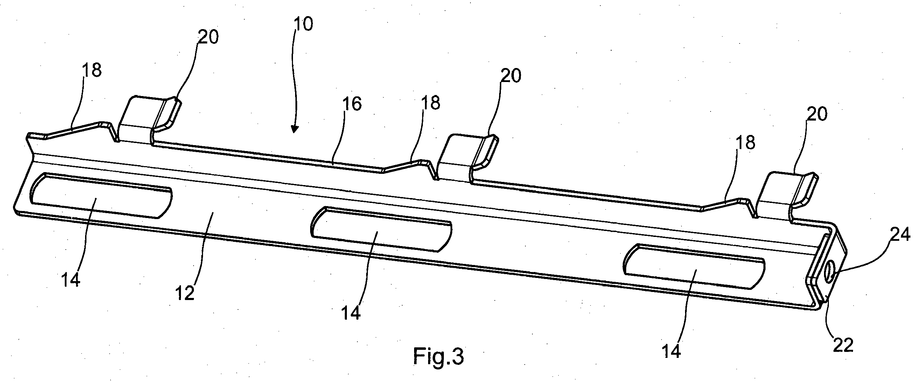

Das Angriffsmittel-Bauteil 8 besteht vorliegend aus einem Blechbauteil mit einem Montage-Blechstreifen 8a, von dem im Wesentlichen rechtwinklig eine Anzahl längsbeabstandeter Laschen 8b vorragen. Jede (oder ausgewählte) Lasche 8b hat an einem (gleichgerichteten) Längsende eine keilförmige Abkantung 8c. Jede (oder ausgewählte) Lasche 8b bildet somit jeweils zwei Angriffsmittel A, B für einen Verriegelungsmechanismus, wie er nachfolgend anhand der Fig. 1 und 3 beschrieben wird.

Der Verriegelungsmechanismus gemäß der Fig. 3 besteht vorliegend aus einem Riegel oder Schieber 10, der durch ein Blech- oder Metallgussbauteil gebildet wird. Er hat einen Montage-Blechstreifen 12, in dem eine Anzahl von längsbeabstandeten Längsschlitzen 14 entsprechend der Anzahl und dem Abstand der Anschraubsockel 6 ausgeformt sind. Des Weiteren ist der Montage-Blechstreifen 12 an einer Längskante zu einer Leiste 16 (90°) abgekantet, an deren freier Oberkante im Längsabstand eine Anzahl von keilförmigen Rampen 18 sowie laschenförmigen Rastnasen 20 ausgeformt sind. Die Zahl und die Positionierung der Rampen 18 und Rastnasen 20 ist so gewählt, dass für den Fall, das der Schieber 10 längs des Angriffsmittel-Bauteils 8 in eine erste Längsrichtung relativ bewegt wird, die Rastnasen 20 mit den Laschen 8b des Angriffsmittel-Bauteils 8 an jeweils zugewandten Seitenkanten (repräsentieren ein zugehöriges Angriffsmittel) B hinterschneidend und damit heranziehend in Eingriff kommen, während die Rampen 20 von den Laschen 8b des Angriffsmittel-Bauteils 8 an jeweils zugewandten Seiten-Abkantungen (repräsentieren ebenfalls deren zugehörigen Angriffsmitteln) A beabstandet werden. Wird der Schieber 10 in die entgegen gesetzte Längsrichtung bewegt, kommen die Rastnasen 20 von den Laschen 8b des Angriffsmittel-Bauteils 8 außer Eingriff, wohingegen die Rampen 18 mit den Laschen 8b des Angriffsmittel-Bauteils 8 in wegdrückenden Eingriff kommen. Dieser Vorgang wird nachfolgend noch genauer im Rahmen der Funktionsbeschreibung des Verriegelungsmechanismus beschrieben.

Der Riegel/Schieber 10 hat an einem Längsende eine senkrecht zum Montageblechstreifen 12 sich erstreckende Abkantung 22, in der ein Durchgangsloch 24 ausgeformt ist, wie dies insbesondere in der Fig. 3 dargestellt ist. Die Ausrichtung des Durchgangslochs 24 verläuft parallel zur Schieberichtung des Riegels/Schiebers 10. Abschließend sei darauf hingewiesen, dass die Wirkrichtungen der Rastnasen 20 und der keilförmigen Rampen 18 entgegengesetzt sind. D.h. während die Rastnasen 20 ein Hintergreifen in die eine Längs-Verschieberichtung begünstigen, sind die Rampen 18 in die entgegen gesetzte Längsverschieberichtung abfallend, d.h. die Keilwirkung erfolgt in die entgegen gesetzte Längsverschieberichtung.

Die Montage des erfindungsgemäßen Gehäuses sowie die Wirkungsweise des Verriegelungsmechanismus wird nachfolgend anhand der Fig. 1 beschrieben.

Gemäß der Fig. 1 sind an den (beiden) gegenüberliegenden Längskanten der Bodenplatte 1 jeweils eine Anzahl der Anschraubsockel 6 angeformt. Zwei Riegel/Schieber 10 sind an deren jeweiligen Montage-Blechstreifen 12 an den Anschraubsockeln 6 längsverschiebbar montiert, indem die Anschraubsockel 6 durch die Längsschlitze 14 in dem Montage-Blechstreifen 12 hindurchgeführt sind, wobei abschließend Halteschrauben 26 auf die Anschraubsockel 6 aufgedreht sind, welche ein Abheben der Riegel/Schieber 10 von den Anschraubsockeln 6 verhindert. Die beiden Riegel/Schieber 10 können so parallel zueinander an der Bodenplatte 1 längsverschoben werden. Die jeweiligen Längsleisten 16 mit den Rastnasen 20 und den Rampen 18 liegen dabei auf der nach Außen gerichteten Längsseite jedes Riegels/Schiebers 10 sowie im Wesentlichen senkrecht zur Bodenplatten-Innenseite.

Zur Betätigung der Riegel/Schieber 10 ist jeweils ein Betätigungsmechanismus vorgesehen. Dieser besteht vorliegend jeweils aus einer Stellschraube 28, die in die Bodenplatte 1 in Riegel/Schieber - Längsrichtung eingedreht ist und welche endseitig in dem jeweiligen Durchgangsloch 24 des zugehörigen Riegels/Schiebers 10 drehbar jedoch axial fix verankert ist. D.h. bei Drehen der Stellschraube 28 an der Bodenplatte 1 wird diese in Schraubenlängsrichtung bewegt, wobei sich diese Bewegung auf den angedockten Riegel/Schieber 10 für dessen Längsverschiebung überträgt.

An jeder Seitenplatte 2 ist an zumindest einer Längskante, vorliegend an zwei sich gegenüberliegende Längskanten jeweils ein Angriffsmittel-Bauteil 8 fixiert (durch Anschrauben, Annieten, Anschweißen, etc.), derart, dass dessen die Angriffsmittel A, B definierenden Laschen 8b mit den Rampen 18 und Rastnasen 20 des zugehörigen Schiebers 10 in Eingriff bringbar sind.

Um nunmehr das Gehäuse aus den genannten Gehäuseteilen zusammen zu bauen, werden beispielsweise die beiden gezeigten Seitenplatten 2 hochkant in die an der Bodenplatte 1 ausgeformten Nuten 4 eingepresst. Anschließend werden die beiden Riegel/Schieber 10 mittels der Stellschrauben 28 betätigt/verschoben, derart, dass die daran ausgebildeten Rastnasen 20 die an den Angriffsmittel-Bauteilen 8 ausgebildeten Laschen 8b hintergreifen und dadurch gegen sich ziehen. Dabei werden die beiden Seitenplatten 2 fester in die Nuten 4 gezogen und dort unter einer hohen Vorspannkraft (aufgebracht über die Stellschrauben) quasi selbsthemmend gehalten. Durch diese Maßnahme wird eine dichte sowie für elektromagnetische Strahlung undurchlässige Verbindung zwischen den gezeigten Seitenplatten 2 und der Bodenplatte 1 erreicht.

Um eine der Seitenplatten 2 beispielsweise zu Wartungszwecken an eingehausten Geräteelementen (nicht dargestellt) zu entfernen, wird die entsprechende Stellschraube 28 entgegengesetzt gedreht und damit der Riegel/Schieber 10 in eine Richtung geschoben, in welcher die Rastnasen 20 außer Eingriff von den Laschen 8b des Angriffsmittel-Bauteils 8 kommen und statt dessen die Rampen 18 an den Laschen 8b in drückende Anlage kommen. Dadurch wird entsprechend der Keilform der Rampen 18 die betreffende Seitenplatte 2 aus der Nut 4 an der Bodenplatte 1 herausgedrückt.

Es liegt auf der Hand, dass anstelle einer Vielzahl von individuell für jeden Riegel/Schieber 10 angeordnete Stellschraube 28 auch eine Gemeinschaftsschraube zur Betätigung mindestens zweier paralleler Riegel/Schieber 10 angeordnet sein kann. Auch können die Riegel/Schieber 10 statt an der Bodenplatte 1 (und der nicht weiter gezeigten Zugangshaube) an den Seitenplatten 2 angeordnet sein. Schließlich müssen die Angriffsstellen nicht notwendiger Weise durch die gezeigten Laschen gebildet sein sondern können auch durch Dübel oder Bolzen ausgebildet werden, welche in das Angriffsmittel-Bauteil eingesetzt sind.

## Patentansprüche

1. Gehäuse eines elektrischen oder elektronischen Geräts vorzugsweise der medizinischen Bauart mit wenigstens einer Zugangshaube, Zugangsdeckel oder dergleichen Gehäuseteil, das für ein Verschließen des Gehäuses oder einer Gehäuseöffnung mittels eines von Außerhalb des Gehäuses betätigbaren Verriegelungsmechanismus am Gehäuse fixierbar ist, **dadurch gekennzeichnet, dass** der Verriegelungsmechanismus wenigstens einen an dem einen Teil nämlich am Gehäuse oder an der Zugangshaube/Zugangsdeckel längsverschiebbar gehaltenen Riegel/Schieber (10) hat, an dem zumindest eine Rampe (18) und zumindest eine hierzu in Schieberichtung beabstandete Hinterschneidung oder Rastnase (20) vorgesehen ist, wohingegen an dem anderen Teil nämlich an der Zugangshaube/Zugangsdeckel oder dem Gehäuse wenigstens ein Vorsprung (8b) vorgesehen ist, der zur Definition wenigstens zweier Angriffsmittel (A, B) so ausgebildet und/oder angeordnet ist, dass die Angriffsmittel in Abhängigkeit von der aktuellen Schiebeposition des Riegels/Schiebers (10) wechselweise mit der zugehörigen Rastnase (20) für ein Heranziehen an das Gehäuse oder mit der Rampe (18) für ein Wegdrücken der Zugangshaube/Zugangsdeckel von dem Gehäuse in Wirkeingriff kommen.

2. Gehäuse nach Anspruch 1, **gekennzeichnet durch** eine Bodenplatte (1), eine Anzahl von Seitenwänden (2) sowie die zumindest eine Zugangshaube oder Zugangsdeckel, die nach dem Nut- und Feder-Prinzip miteinander zusammensteckbar sind.

3. Gehäuse nach Anspruch 2, **dadurch gekennzeichnet, dass** zumindest an der Gehäuseinnenseite der Bodenplatte (1) längs deren Umfang zumindest eine oder mehrere Nuten (4) ausgebildet sind, deren jeweilige Nutentiefe senkrecht zur Gehäuseinnenseite ausgerichtet ist zur hochkantigen Steckaufnahme der Seitenwände (2) und vorzugsweise der Zugangshaube/Zugangsdeckel.

4. Gehäuse nach einem der vorstehenden Ansprüche, **dadurch gekennzeichnet, dass** an zumindest einem oder ausgewählten Gehäuseteilen nämlich der Bodenplatte (1), den Seitenwänden (2) und/oder der Zugangshaube/Zugangsdeckel randseitig eine Anzahl von seriell beabstandeten Führungszapfen (6) an der jeweiligen Gehäuseinnenseite des entsprechenden Gehäuseteils ausgeformt sind, die zur Längsführung des Riegels/Schiebers (10) vorgesehen sind.

5. Gehäuse nach einem der vorstehenden Ansprüche, **dadurch gekennzeichnet, dass** der Riegel/Schieber (10) aus einem Blech- oder Metallgussbauteil gefertigt ist.

6. Gehäuse nach Anspruch 4, **dadurch gekennzeichnet, dass** der Riegel/Schieber (10) eine Anzahl von seriell längsbeabstandeten Durchgangslängsschlitzen (14) aufweist, in welche die Führungszapfen (6) längsgleitend eingesetzt oder einsetzbar sind.

7. Gehäuse nach einem der vorstehenden Ansprüche, **gekennzeichnet durch** eine Betätigungseinrichtung zur Längsverschiebung des jeweiligen Riegels/Schiebers (10) von Außerhalb des Gehäuses.

8. Gehäuse nach Anspruch 7, **dadurch gekennzeichnet, dass** der Betätigungsmechanismus eine Stellschraube (28) ist, welche an einem ausgewählten Gehäuseteil nämlich der Bodenplatte (1), den Seitenplatten (2) und/oder der Zugangshaube/Zugangsdeckel in Schieberichtung des zugehörigen Riegels/Schiebers (10) eingedreht und stirnseitig mit dem zugehörigen Riegel/Schieber (10) in Eingriff ist, um diesen in seine Längsrichtung zu drücken und zu ziehen.

9. Gehäuse nach einem der vorstehenden Ansprüche, **dadurch gekennzeichnet, dass** der zumindest eine Vorsprung (8b) durch ein separates Angriffsmittel-Bauteil (8) bereitgestellt wird, welches an ausgewählte Gehäuseteile nämlich der Bodenplatte (1), den Seitenwänden (2) und/oder der Zugangshaube/Zugangsdeckel fixiert/fixierbar ist.

10. Gehäuse nach Anspruch 9, **dadurch gekennzeichnet, dass** das AngriffsmittelBauteil (8) vorzugsweise als Blechbauteil eine Anzahl von laschen- oder bolzenförmigen, längsbeabstandeten Vorsprüngen (8b) hat, welche jeweils ein oder zwei Angriffsmittel (A, B) für das Zusammenwirken mit der zumindest einen Rastnase (20) und/oder der zumindest einen Rampe (18) am Riegel/Schieber (10) definieren.

## Claims

1. Casing for an electrical or electronic device, especially of the medical type, having at least one access hood, access cover or similar casing part which, for the purpose of closing the casing or a casing opening, can be fixed to the casing by means of a locking mechanism which can be actuated from outside the casing, **characterised in that** the locking mechanism has at least one bar/slide (10) which is held in a longitudinally displaceable manner on one part, namely on the casing or on the access hood/access cover, and on which there are provided at least one sloping portion (18) and at least one undercut or catch (20) which is spaced apart from the sloping portion in the sliding direction, while there is provided on the other part, namely on the access hood/access cover or on the casing, at least one projection (8b) which, for the purpose of defining at least two engagement means (A, B), is so designed and/or arranged that, in dependence on the current sliding position of the bar/slide (10), the engagement means come into operative engagement alternately with the associated catch (20), in order to pull the access hood/access cover towards the casing, or with the sloping portion (18), in order to push the access hood/access cover away from the casing.

2. Casing according to claim 1, **characterised by** a base plate (1), a plurality of side walls (2) and the at least one access hood or access cover, which can be fitted together by the tongue-and-groove principle.

3. Casing according to claim 2, **characterised in that** at least one or more grooves (4) are formed along the periphery of the base plate (1) at least on the side thereof facing the inside of the casing, the depth of which grooves is oriented perpendicularly to the inside of the casing for the purpose of receiving the side walls (2) and preferably the access hood/access cover in an upright position.

4. Casing according to any one of the preceding claims, **characterised in that,** on at least one casing part or on selected casing parts, namely the base plate (1), the side walls (2) and/or the access hood/access cover, a plurality of serially spaced apart guide pins (6) are formed at the edges of the corresponding casing part, in each case on the side facing the inside of the casing, which guide pins are provided for longitudinally guiding the bar/slide (10).

5. Casing according to any one of the preceding claims, **characterised in that** the bar/slide (10) is produced from a sheet metal or cast metal component.

6. Casing according to claim 4, **characterised in that** the bar/slide (10) has a plurality of through-slots (14) which are serially longitudinally spaced apart and into which the guide pins (6) are inserted or can be inserted in a longitudinally sliding manner.

7. Casing according to any one of the preceding claims, **characterised by** an actuating device for longitudinally displacing the bar/slide (10) from outside the casing.

8. Casing according to claim 7, **characterised in that** the actuating mechanism is an adjusting screw (28) which is screwed onto a selected casing part, namely the base plate (1), the side plates (2) and/or the access hood/access cover, in the sliding direction of the associated bar/slide (10) and is in engagement at the front end with the associated bar/slide (10) in order to push and pull the bar/slide in the longitudinal direction thereof.

9. Casing according to any one of the preceding claims, **characterised in that** the at least one projection (8b) is provided by a separate engagement means component (8) which is fixed/can be fixed to selected casing parts, namely the base plate (1), the side walls (2) and/or the access hood/access cover.

10. Casing according to claim 9, **characterised in that** the engagement means component (8), preferably in the form of a sheet metal component, has a plurality of lug- or bolt-shaped projections (8b) which are longitudinally spaced apart and each define one or two engagement means (A, B) for cooperation with the at least one catch (20) and/or the at least one sloping portion (18) on the bar/slide (10).

## Revendications

1. Boîtier d'un appareil électrique ou électronique, de préférence du type médical avec au moins un capot d'accès, un couvercle d'accès ou une partie de boîtier similaire, qui peut être fixée sur le boîtier pour une fermeture du boîtier ou d'une ouverture de boîtier à l'aide d'un mécanisme de verrouillage actionnable depuis l'extérieur du boîtier, **caractérisé en ce que** le mécanisme de verrouillage a au moins un verrou/coulisseau (10) maintenu de manière coulissante longitudinalement sur l'une partie, à savoir sur le boîtier ou sur le capot d'accès/couvercle d'accès, sur lequel verrou/coulisseau au moins une rampe (18) et au moins une contre-dépouille ou un nez d'encliquetage (20) espacé à cet effet dans le sens coulissant est prévu, alors qu'au moins une saillie (8b) est prévue sur l'autre partie, à savoir sur le capot d'accès/couvercle d'accès ou le boîtier, laquelle est réalisée et/ou agencée pour la définition au moins de deux moyens d'attaque (A, B) de sorte que les moyens d'attaque viennent en engagement actif en fonction de la position coulissante actuelle du verrou/coulisseau (10) alternativement avec le nez d'encliquetage afférent (20) pour un rapprochement du boîtier ou avec la rampe (18) pour un enlèvement du capot d'accès/couvercle d'accès hors du boîtier.

2. Boîtier selon la revendication 1, **caractérisé par** une plaque de fond (1), un nombre de parois latérales (2) ainsi que l'au moins un capot d'accès ou couvercle d'accès qui sont enfichables selon le principe de rainure et languette entre eux.

3. Boîtier selon la revendication 2, **caractérisé en ce qu'**au moins une ou plusieurs rainures (4) sont réalisées au moins sur le côté intérieur de boîtier de la plaque de fond (1) le long de sa périphérie, dont la profondeur de rainure respective est orientée perpendiculairement au côté intérieur de boîtier pour la réception par enfichage sur chant des parois latérales (2) et de préférence du capot d'accès/couvercle d'accès.

4. Boîtier selon l'une quelconque des revendications précédentes, **caractérisé en ce qu'**un nombre de tenons de guidage (6) espacés en série sont formés sur le côté intérieur de boîtier respectif de la partie de boîtier correspondante sur au moins une ou des parties de boîtier sélectionnées à savoir la plaque de fond (1), les parois latérales (2) et/ou le capot d'accès/couvercle d'accès côté bord, lesquels tenons sont prévus pour le guidage longitudinal du verrou/coulisseau (10).

5. Boîtier selon l'une quelconque des revendications précédentes, **caractérisé en ce que** le verrou/coulisseau (10) est fabriqué en un composant de tôle ou coulé en métal.

6. Boîtier selon la revendication 4, **caractérisé en ce que** le verrou/coulisseau (10) présente un nombre de fentes longitudinales de passage (14) espacées sur la longueur en série, dans lesquelles les tenons de guidage (6) peuvent être ou sont insérés par glissement longitudinal.

7. Boîtier selon l'une quelconque des revendications précédentes, **caractérisé par** un dispositif d'actionnement pour le coulissement longitudinal du verrou/coulisseau respectif (10) depuis l'extérieur du boîtier.

8. Boîtier selon la revendication 7, **caractérisé en ce que** le mécanisme d'actionnement est une vis de réglage (28) qui est vissée sur une partie de boîtier sélectionnée à savoir la plaque de fond (1), les plaques latérales (2) et/ou le capot d'accès/couvercle d'accès dans le sens coulissant du verrou/coulisseau afférent (10) et est en engagement côté avant avec le verrou/coulisseau afférent (10) afin de presser et serrer celui-ci dans son sens longitudinal.

9. Boîtier selon l'une quelconque des revendications précédentes, **caractérisé en ce que** l'au moins une saillie (8b) est mise à disposition par un composant de moyen d'attaque séparé (8) qui est ou peut être fixé sur des parties de boîtier sélectionnées à savoir la plaque de fond (1), les parois latérales (2) et/ou le capot d'accès/couvercle d'accès.

10. Boîtier selon la revendication 9, **caractérisé en ce que** le composant de moyen d'attaque (8) a de préférence comme composant de tôle un nombre de saillies (8b) espacées sur la longueur, en forme de languette ou de boulon qui définissent respectivement un ou deux moyens d'attaque (A, B) pour la coaction avec l'au moins un nez d'encliquetage (20) et/ou l'au moins une rampe (18) sur le verrou/coulisseau (10).
